# EUROPEAN PATENT APPLICATION

(11) **EP 2 365 633 A1**
(43) Date of publication of application: **14.09.2011**
(21) Application number: 09824605.1
(22) Date of filing: 04.11.2009
(51) Int. Cl.: H03M 1/08, H02M 7/48, H03M 1/12

(54) **DIGITAL CONVERSION DEVICE AND POWER CONVERSION DEVICE**

(30) Priority: 05.11.2008 JP 2008283850
(71) Applicant: Panasonic Corporation, Kadoma-shi Osaka 571-8501 (JP)
(72) Inventor: DOYAMA, Yoshiaki, Chuo-ku Osaka 540-6207 (JP); KYOGOKU, Akihiro, Chuo-ku Osaka 540-6207 (JP); KAWASAKI, Tomohiro, Chuo-ku Osaka 540-6207 (JP); TANAKA, Hidehisa, Chuo-ku Osaka 540-6207 (JP)
(74) Representative: Trösch, Hans-Ludwig
(86) International application number: PCT/JP2009/005857
(87) International publication number: WO 2010/052905

(57) **Abstract**

A digital conversion device that removes a pulse-shaped noise component without causing the delay in the obtained information, and a power conversion device that performs power conversion in which the digital conversion device is utilized. The digital conversion device includes: a plurality of information signal holding units (301 etc.) capable of inputting information signals with delay by a predetermined time, the information signals being indicative of a value varying momentarily, and holding the values at a time when each of the values is inputted; a removing unit (307) capable of removing a value farthest from the other values among the values held by the plurality of information signal holding units; an averaging unit (308) capable of averaging the values that are not removed by the removing unit; and a converter (309) capable of performing AD-conversion of a value outputted from the averaging unit and outputting an AD-converted value as digital information. The predetermined time has a value shorter than time required for the conversion to the digital information performed by the converter.

## Description

### TECHNICAL FIELD

The present invention relates to a digital conversion device which converts an analog signal (such as an information signal showing a current value that varies momentarily) into a digital signal, and so-called a power conversion device for power electronics which converts a power form in accordance with a purpose of its use by using the digital conversion device and switching means. Particularly, the present invention relates to a power conversion device that converts AC power to DC power once and further converts the DC power to another AC power, and a power conversion device that converts DC power to a plurality of completely independent AC powers. The power conversion device may be used as power conversion devices in air conditioners and refrigerators for home and business uses, which perform variable-speed drive of electric compressors using AC power and an inverter, for example.

### BACKGROUND ART

The power conversion device may include both of a converter and a inverter. The converter converts AC power to DC power; and the inverter converts the DC power to intended AC power. In order to supply desired electric power to a load (for example, a motor) by controlling the converter and the inverter, usually, current values and voltage values are detected in the converter and the inverter, and based on a detected values, the converter and the inverter are controlled.

Conventional power conversion devices are designed so that control circuits for controlling the converter and the inverter are separately implemented, or sensed information to be used for the control can be obtained through a state being insulated from a power system. Particularly, in a sensing of input or output current, instantaneous current is generally sensed from a state insulated from the power system using a Hall effect current sensor (for example, refer to Patent Literature 1 (JP 2006-158155 A)). However, this requires the Hall effect current sensor. The Hall effect current sensor gets more expensive, as higher accuracy is required.

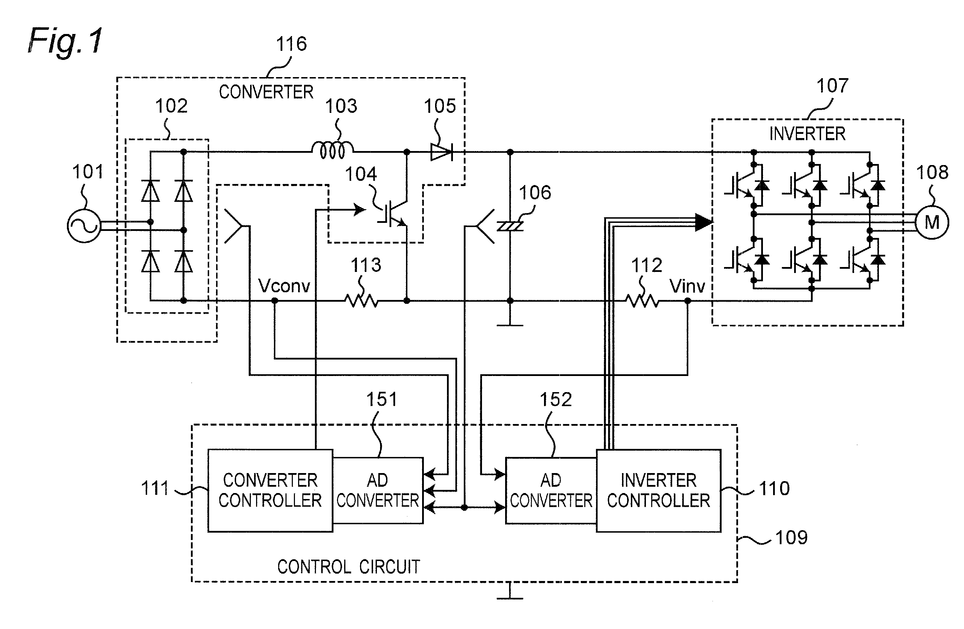

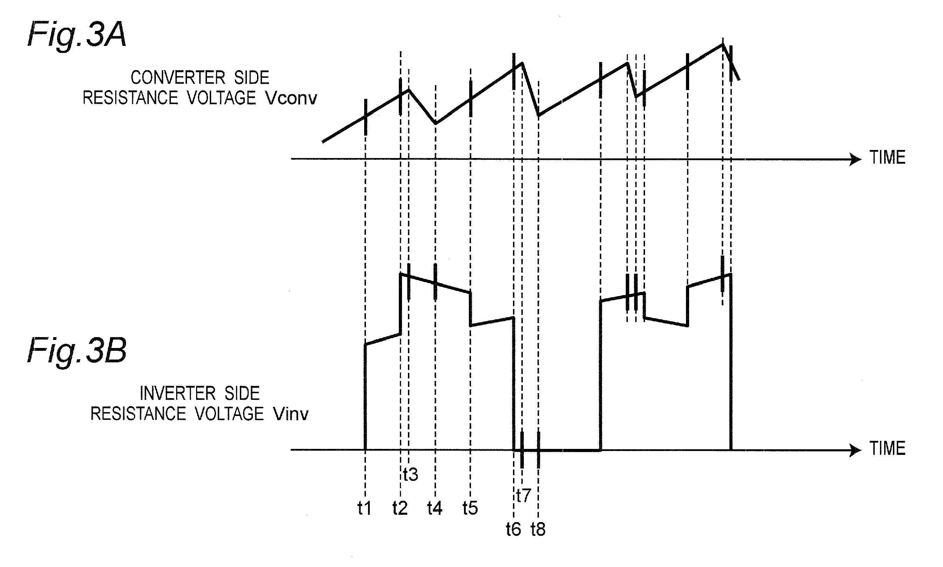

Meanwhile, it is also well-known that other type of a power conversion device obtains current sensing information with the use of a low resistor inserted into a system the current of which is to be sensed instead of the current sensor. The power conversion device senses the potentials of both ends of the resistor to obtain the current sensing information (see resistors 112 and 113 of Fig. 1). In this case, when a control circuit and one end of a capacitor are set to a common potential, the potential of one end of one of the resistors becomes a value proportional to a converter current, and the potential of one end of the other resistor becomes a value proportional to an inverter current. Thus, by using such values, a converter control, which means a control of power supply current, and an inverter control, which means a drive control of a motor, can be realized. However, in a real circuit, it is difficult to obtain a complete coincidence of the potential of one end of the capacitor, the potential of one ends of two resistors, and a reference potential of the control circuit. Further, in the circuit of the power conversion device, there is an inductance component in addition to a resistance component, and a voltage proportional to the instantaneous current is not necessarily generated. Particularly, in power electronics, power conversion is carried out while changing routes by switching, and therefore the circuit has a line where the current flows intermittently, thus generating a great voltage instantaneously due to the inductance component, resulting in noise. In order to reduce such noise, the inductance component needs to be reduced, and a method of making wiring thick and short is employed. However, the parts actually used have certain specific sizes and therefore there is a limitation in shortening the wiring. Consequently, two pieces of information from a side of a converter and a side of an inverter interfere with each other. Specifically, a pulse-shaped noise is superimposed on a converter side detected voltage at timings of a drastic variation of an inverter side resistor voltage (see Fig. 3A), and the pulse-shaped noise is superimposed on the inverter side detected voltage at timings of actual ON/OFF states of converter side IGBT (see Fig. 3B). As stated, at both sides of the converter side and the inverter side, pulse noise is superimposed by a variation edge of IGBT, and therefore such pulse noise needs to be removed.

For example, when the control circuit is realized as one control circuit, the following methods can be considered: a method of monitoring all time variation of IGBT used in the converter and the inverter and not using voltages of two resistors in the period for sensing information; and a method of obtaining the sensing information from voltage outputs from two resistors which is passed through a treble cutoff filter. In the case where the voltage information during the variation is not read through the monitoring of the timing of the variation of the IGBT, accurate timing of the variation needs to be known. However, an actual timing of the variation of the IGBT is slightly deviated from the timing determined by the control circuit, and therefore it is difficult and unrealistic to know the accurate timing of the variation. Similarly, a read timing is deviated when the voltage output is passed through the treble cutoff filter, and therefore when information of a plurality of phases is included in a waveform on the inverter side in a time division manner, there is a possibility that information of different phase is erroneously mixed, and hence this is unrealistic to obtain a great effect. Particularly, if the voltage output is passed through the treble cutoff filter, a delay is caused in obtained information, thus making it difficult to realize stable and highly accurate control. Therefore, in the power conversion device having the converter and inverter, there is no simple method to remove the noise.

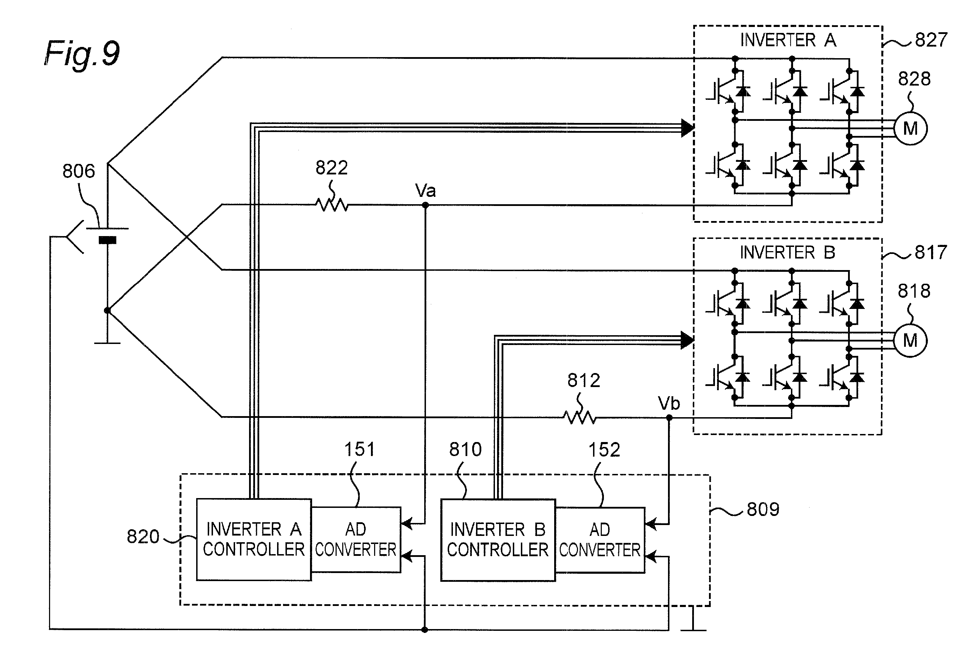

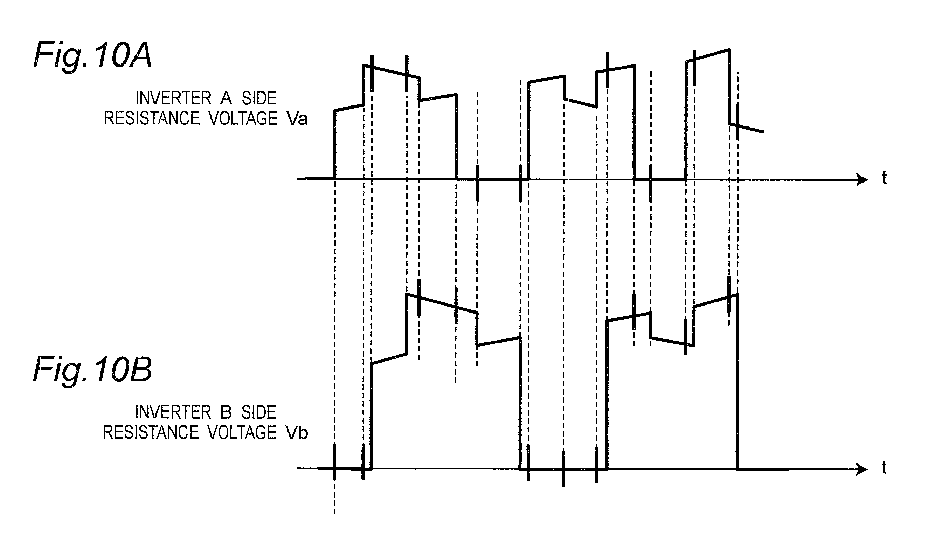

Further, there is also a power conversion device for converting DC power to a plurality of completely independent AC powers (see Fig. 9). However, even when independently controlling a plurality of motors from DC power supply through a plurality of inverters, pulse noise is imparted to the other current waveform by the current information obtained by a plurality of current detection resistors, at timings of a drastic variation of each current (see Figs. 10A and 10B). In this case as well, the pulse noise needs to be removed for realizing the stable and highly accurate control. However, in this case as well, a problem similar to the aforementioned problem occurs.

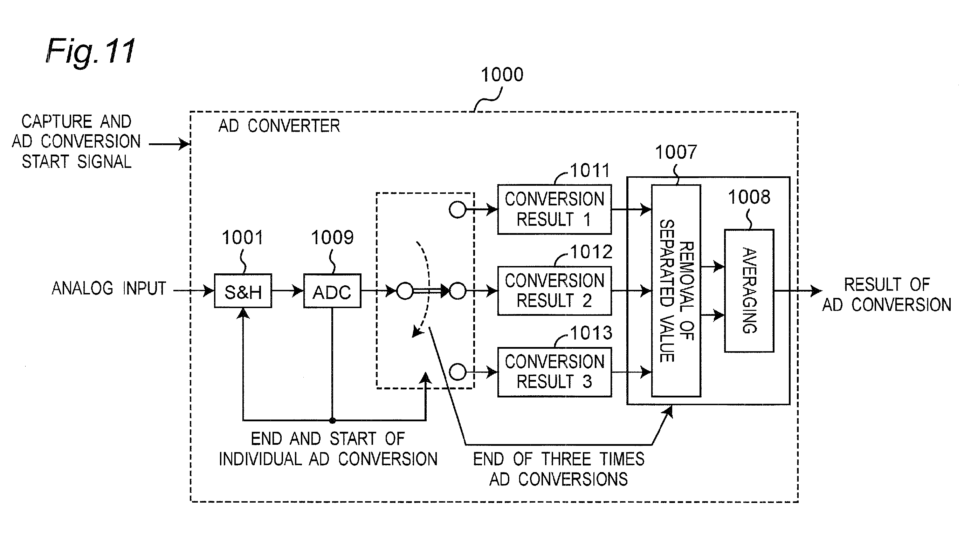

Therefore, the conventional power conversion device has an AD converter for removing the pulse noise. Fig. 11 is a circuit configuration diagram showing a principle of removing noise of an AD converter of a generally-known one chip microcomputer. In order to realize such digital control, first, an AD converter 1000 holds analog information to a fixed analog value by passing the analog information through a sample-and-hold circuit (S & H) 1001 so that a value of the analog information is not varied during AD conversion. An AD converter circuit (ADC) 1009 converts the held analog value to a digital value, and stores this digital value sequentially in storage means 1011, 1012, and 1013, as a conversion result 1, a conversion result 2, and a conversion result 3 at every conversion. When three conversions are ended, a separated value removing circuit 1007 removes a value farthest from the other values, and averaging circuit 1008 averages the remaining values. Thus, an influence of the pulse-shaped noise is removed.

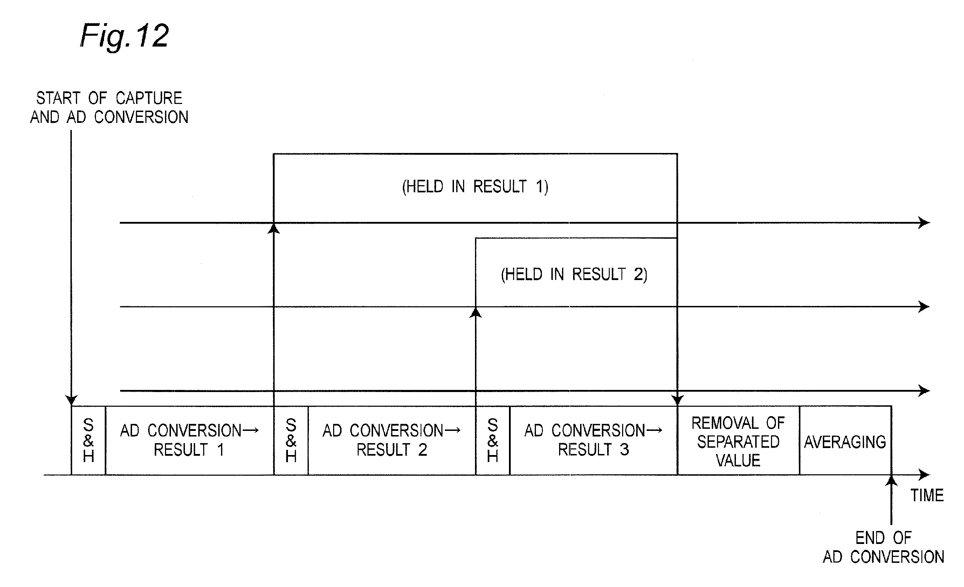

Fig. 12 shows the conversion and computation by the AD converter 1000 in time series. The AD converter 1000 receives a signal to start capturing analog information and AD conversion of the analog information from a system including entire systems of an air conditioner etc. being equipped with the power conversion device therein. Then the AD converter 1000 performs a first AD conversion and stores and holds the result as conversion result 1. When the first AD conversion is finished, second AD conversion is performed and its result is stored and held as conversion result 2. When the second AD conversion is finished, third AD conversion is performed and its result is obtained. When the third AD conversion is finished, the value farthest from the other values is removed from the three AD conversion results obtained heretofore; and thereby an averaged result of the remaining values after removing the value farthest from the other values is obtained. Thereafter, this averaged result is used as a result of AD conversion with the noise removed.

### CITATION LIST

### PATENT LITERATURE

Patent Literature 1: JP 2006-158155 A

### SUMMARY OF INVENTION

### TECHNICAL PROBLEM

However, As mentioned, a pulse-shaped noise component may be removed in the conventional AD conversion. However, it is required a long time to obtain the AD conversion result from the start of the first AD conversion (namely, from the reception of a signal to start the capturing and AD conversion of the derivation of the averaged output). Therefore, the information is obtained with delay, thus it involves a problem that stable and highly accurate control is hardly realized in a control circuit which uses the information obtained with delay.

The present invention has been made to solve the above-described problem and an object of the present invention is to provide: a digital conversion device that removes a pulse-shaped noise component and provides the information without delay; and a power conversion device that performs power conversion by utilizing the digital conversion device.

### SOLUTION TO PROBLEM

In order to solve the above-described problem, a digital conversion device is provided according to the present invention. The digital conversion device includes: a plurality of information signal holding units capable of inputting information signals with delay by a predetermined time, the information signals being indicative of a value varying momentarily, and holding the values at a time when each of the values is inputted; a removing unit capable of removing a value farthest from the other values among the values held by the plurality of information signal holding units; an averaging unit capable of averaging the values that are not removed by the removing unit; and a converter capable of performing AD-conversion of a value outputted from the averaging unit and outputting an AD-converted value as digital information. The predetermined time has a value shorter than time required for the conversion to the digital information performed by the converter. The timing of capturing the information signals by the plurality of information signal holding units is made shorter than time required for conversion to the digital information performed by the converter, and therefore the digital information can be outputted in a short period of time. Further, the value farthest from the other values is removed by the removing unit, and therefore the noise can be removed even if the pulse-shaped noise is included in the predetermined time. Therefore, it is possible to remove the pulse-shaped noise and the delay is not caused in the obtained information. Thus, highly accurate information signals for control can be obtained quickly. Accordingly, control accuracy can be enhanced. Further, the present invention has an advantage in that a circuit is simple, because processing is performed by a simple analog circuit (namely, AD conversion is performed after removing the noise).

A digital conversion device according to another aspect of the present invention includes: a plurality of information signal holding units capable of inputting information signals with delay by a predetermined time, the information signals being indicative of a value varying momentarily, and holding the values at a time when each of the values is inputted; a plurality of converters capable of performing AD-conversion of the values held by the plurality of information signal holding units and outputting digital values; a removing unit capable of removing a digital value farthest from the other digital values among the digital values outputted from the converters; and an averaging unit capable of averaging the digital values that are not removed by the removing unit and outputting an averaged value as digital information. The predetermined time has a value shorter than time required for the conversion to the digital value performed by each one of the plurality of converters. The timing of capturing the information signals by the plurality of information signal holding units is made shorter than the time required for conversion to the digital information performed by each of the converters, and therefore the digital information can be outputted in a short period of time. Further, the value farthest from the other values is removed by the removing unit, and therefore the noise can be removed even if the pulse-shaped noise is included in the predetermined time. Therefore, it is possible to remove the pulse-shaped noise component and the delay is not caused in the obtained information. Thus, the highly accurate information signals for control can be obtained quickly. Accordingly, control accuracy can be enhanced. In the present invention, the number of circuit elements is increased, because the computation of removing the noise is performed after digital conversion. However, each circuit element requires not so much excellent performance, and therefore there is an advantage in that the circuit of the present invention is easily realized as a large scale integrated circuit (LSI).

Preferably, the number of the information signals held by the plurality of information signal holding units may be three or more. Thus, the pulse-shaped noise can be surely removed.

The information signals inputted into the plurality of information signal holding units may be indicative of current values. Current information is often drastically varied during power conversion, by the change of a route through which the current flows. In other words, the current information is the information most remarkably showing a control state. Therefore, the power conversion device having the digital conversion device is capable of achieving a highly accurate power conversion by quickly capturing the variation of the current information.

Preferably, the predetermined time may be larger than a time width of pulse-shaped noise included in the information signals inputted into the plurality of information signal holding units. Thus, the information signal of before or after delay that is not disturbed by the noise can be held even if information signals are disturbed by one pulse noise.

The removing unit may remove a maximum value and a minimum value. Thus, a held value that has been disturbed by the pulse-shaped noise can be easily and surely removed.

A power conversion device according to the present invention includes: a DC power converter capable of converting an output of an AC power supply to DC power using a switching element; an AC power converter capable of converting the DC power outputted from the DC power converter to AC power; a control circuit capable of controlling the DC power converter and the AC power converter based on digital current information; resistors which are connected to DC power portions in the DC power converter and the AC power converter; and an aforementioned digital conversion device. The aforementioned digital conversion device detects a direct current in the DC power converter and an alternating current in the AC power converter by detecting voltages of one ends of the resistors with referring voltages of other ends of the resistors as references and converts each of the detected direct current and the detected alternating current to the digital current information. The pulse-shaped noise can be easily removed in a short period of time by the digital conversion device, and therefore the control accuracy in power conversion can be enhanced with a simple circuit configuration. Further, information regarding the current of the DC power converter and the AC power converter can be detected only by detecting a voltage of one end of each resistor, and therefore the power conversion device can be realized with the simple circuit configuration.

A power conversion device according to another aspect of the present invention includes: a plurality of AC power converters capable of converting an output from a quasi-DC power supply to a plurality of AC powers, the quasi-DC power supply converting a DC power supply or an AC power supply to a direct current; a control circuit capable of controlling the plurality of AC power converters based on digital current information; resistors which are connected to each of routes from the DC power supply or the AC power supply to each of the plurality of AC power converters; and an aforementioned digital conversion device. The aforementioned digital conversion device detects an alternating current in the plurality of AC power converters by detecting voltages of one ends of the resistors with referring voltages of other ends of the resistors as references and converts each of the detected alternating currents to the digital current information. The pulse-shaped noise can be easily removed in a short period of time by the aforementioned digital conversion device, and therefore the control accuracy in power conversion can be enhanced with a simple circuit configuration. Further, information regarding the currents of the plurality of AC power converters can be detected only by detecting a voltage of one end of each resistor, and therefore the power conversion device can be realized with the simple circuit configuration. Particularly, when driving a motor etc. using an inverter, the present invention exhibits a great advantageous effect since a leak current is sometimes gotten into its inverter system as noise via another motor due to a pulse-shaped leak current generated via a stray capacitance between the motor and their casing (covering casing).

### ADVANTAGEOUS EFFECTS OF INVENTION

According to the present invention, by sampling and holding the information signals (such as signals showing values of the current) at a shorter interval than the time required for conversion to digital information, a signal after digital conversion with noise removed can be outputted in a short period of time. Therefore, the pulse-shaped noise component can be removed and the information can be obtained without delay. Thus, control of the stable and highly accurate power conversion is achieved.

### BRIEF DESCRIPTION OF DRAWINGS

Fig. 1 is a circuit block diagram of an overall configuration of a power conversion device according to Embodiments 1 to 3 of the present invention.
Fig. 2 is a configuration diagram of an AD converter according to the Embodiment 1 of the present invention.
Fig. 3A is a diagram showing an example of a converter side voltage on which noise is ridden.
Fig. 3B is a diagram showing an example of an inverter side voltage on which noise is ridden.
Fig. 4 is a chart of an operation timing of the AD converter of Fig. 2.
Fig. 5 is a diagram showing a timing of sampling of a sample-and-hold circuit of Fig. 2.
Fig. 6 is a configuration diagram of an AD converter according to Embodiment 2 of the present invention.
Fig. 7 is a chart of an operation timing of the AD converter of Fig. 6.
Fig. 8 is a configuration diagram of an AD converter according to Embodiment 3 of the present invention.
Fig. 9 is a circuit block diagram of an overall configuration of a power conversion device according to Embodiment 4 of the present invention.
Fig. 10A is a diagram showing an example of one of inverter side voltages on which noise is ridden.
Fig. 10B is a diagram showing an example of another one of inverter side voltages on which noise is ridden.
Fig. 11 is a configuration diagram of a conventional AD converter.
Fig. 12 is a chart of an operation timing of the conventional AD converter.

### DESCRIPTION OF EMBODIMENTS

Embodiments of the present invention will be described below with reference to the drawings.

### Embodiment 1

A power conversion device according to Embodiment 1 of the present invention includes an AD converter that samples and holds a value of the current at a shorter interval than time required for conversion to digital information. The power conversion device achieves a stable and highly accurate control by acquiring an output after the digital conversion from the AD converter with noise removed in a short period of time. The power conversion device of this embodiment may be incorporated in a system such as an air conditioner.

1.1 Configuration of the power conversion device Fig. 1 is an overall configuration diagram of the power conversion device according to the Embodiment 1 of the present invention. The power conversion device of this embodiment includes: an active converter circuit (DC power converter) 116 which converts AC power outputted from an AC power supply 101 to DC power; a smoothing capacitor 106 which smoothes a rectified current outputted from the converter circuit 116; an inverter circuit (AC power converter) 107 which converts DC power obtained through the smoothing by the smoothing capacitor 106 to AC power; and a control circuit 109 which controls the converter circuit 116 and the inverter circuit 107.

The converter circuit 116 includes: a diode bridge 102 connected to the AC power supply 101; a reactor 103 connected to one end of the diode bridge 102; a fast diode 105 connected to the other end of the reactor 103; and an IGBT 104 with one end connected between the reactor 103 and the diode 105 and the other end connected to a reference potential. The smoothing capacitor 106 is connected between a cathode of the diode 105 and the reference potential. The current rectified by the converter circuit 116 is smoothed by the smoothing capacitor 106 so that the output from the smoothing capacitor 106 may be used as a DC power supply. The inverter circuit 107 may be realized using a three-phase bridge circuit which converts the DC power to quasi three-phase AC power. The quasi three-phase AC power outputted from the inverter circuit 107 is supplied to a motor 108 to drive the motor 108.

In order to detect a direct current of the converter circuit 116, a resistor 113 is connected between the other end of the diode bridge 102 and the reference potential. Similarly, in order to detect an alternating current of the inverter circuit 107, a resistor 112 is connected between the inverter circuit 107 and the reference potential. Potentials of one ends of the resistors 112 and 113 and a potential of one end of the smoothing capacitor 106 are fed from a portion being same as the reference potential of the control circuit 109, and therefore they are approximately the same potentials. Since one end of the control circuit 109 and one end of the smoothing capacitor 106 are set to approximately the same potentials, the potential on the diode bridge 102 side of the resistor 113 shows a value proportional to the current of the converter circuit 116. Therefore, the current proportional to the converter circuit 116 can be detected by detecting a voltage Vconv of one end of the resistor 113, with the reference voltage of the other end as a reference. Similarly, the potential on the inverter 107 side of the resistor 112 shows the value proportional to the current of the inverter 107. Therefore, the value proportional to the current of the inverter 107 can be detected by detecting a voltage Vinv of one end of the resistor 112 with the reference potential of the other end as a reference.

The control circuit 109 includes: an AD converter (digital conversion device) 151 which performs AD-conversion of inputted analog information signals; and a converter controller 111 which controls the converter circuit 116 based on the output of the AD converter 151. The control circuit 109 further includes: an AD converter (digital conversion device) 152 which performs AD-conversion of inputted analog information signals; and an inverter controller 110 which controls the inverter circuit 107 based on the output of the AD converter 152. The control circuit 109 performs a control of power supply current through which the converter circuit 116 is controlled, and a control of driving a motor through which the inverter circuit 107 is controlled. In this embodiment, the control circuit 109 may be realized using a digital computer.

Specifically, the information signals inputted to the AD converter 151 may be the current of the converter circuit 116 detected as voltage at the resistor 113. In addition, output voltage of the diode bridge 102 and voltage of the smoothing capacitor 106 may further be inputted to the AD converter 151. The information signals inputted to the AD converter 152 may be the current of the inverter circuit 107 detected as voltage at the resistor 112. Note that the voltage of the smoothing capacitor 106 may be inputted to the AD converter 152.

For example, the converter controller 111 can input an instantaneous value of an absolute value of the AC voltage by monitoring the output voltage of the diode bridge 102 based on the output of the AD converter 151, and also monitor the output voltage on the DC side by monitoring the voltage of the smoothing capacitor 106. The converter controller 111 performs switching control of the IGBT 104 so that the current waveform same as that of the AC voltage can be obtained, and adjusts the magnitude of an input current waveform so that a desired DC voltage can be obtained. Thus, a rectifier circuit with excellent power factor of a power supply can be realized. On the other hand, the inverter controller 110 can also monitor input voltage on the DC side by monitoring the voltage of the smoothing capacitor 106 based on the output of the AD converter 152.

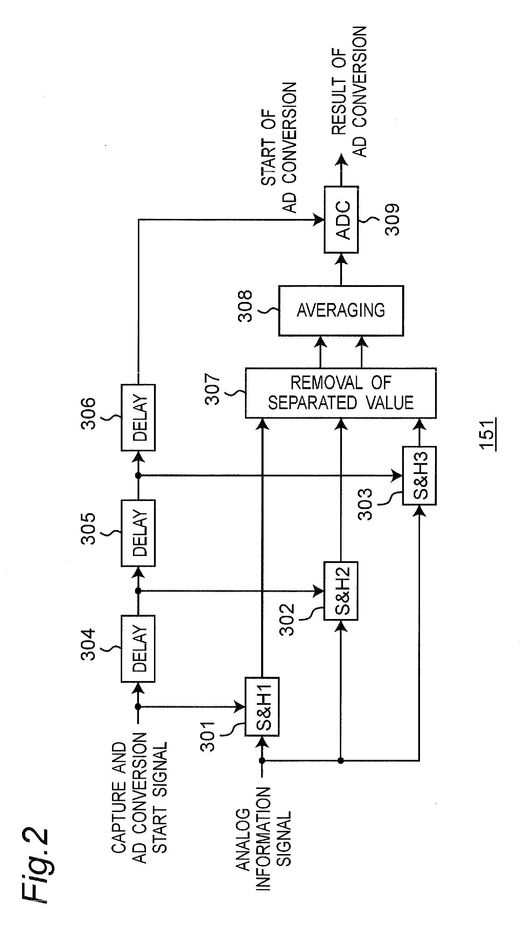

Fig. 2 shows internal configurations of the AD converter 151 and the AD converter 152. The internal configurations of the AD converter 151 and the AD converter 152 are the same, and therefore the AD converter 151 is described by way of example using a case that the AD converter 151 converts the above mentioned information signal to digital information with reference to Fig. 2. The AD converter 151 inputs the analog information signals and a signal for instructing capturing of the information signals and a start of AD conversion, which is internally prepared by the digital computer for starting the control (hereinafter, referred to as "operation start signal"). The AD converter 151 includes: three sample-and-hold circuits (S & H) 301, 302, 303 which sample and hold the inputted information signals; and delay circuits 304, 305, 306 which delay an operation start signal by a predetermined time.

The sample-and-hold circuits (information signal holding units) 301, 302, and 303 are configured using analog switches and capacitors for holding information. Analog information signals to be converted are inputted into the three sample-and-hold circuits 301, 302, and 303. The sample-and-hold circuit 301 samples and holds the inputted information signals based on the operation start signal which instructs capturing the information signals and starting AD conversion. The sample-and-hold circuit 302 samples and holds the inputted information signals based on the operation start signal which is delayed by the delay circuit 304. The sample-and-hold circuit 303 samples and holds the inputted information signals based on the operation start signal which is delayed by the delay circuits 304 and 305. In other words, the sample-and-hold circuits 301, 302, 303 hold values with time elapsed in this order.

The AD converter 151 further includes: a separated value removing circuit 307 which removes the value farthest from the other values from the signals outputted from three sample-and-hold circuits (S & H) 301, 302, and 303; an averaging circuit 308 which averages the values not removed by the separated value removing circuit 307; and an AD converter circuit (ADC) 309 which performs AD-conversion of a value outputted from the averaging circuit 308. The AD converter circuit 309 starts AD conversion at the time further delayed from the time when the sample-and-hold circuit 303 performs the sample-and-hold, based on the operation start signal which is delayed by the delay circuits 304, 305, and 306. Result of the AD conversion outputted from the AD conversion circuit 309 is used for control of the digital computer by the converter controller 111.

In the AD converters 151 and 152 of this embodiment, the predetermined time required for delaying the operation start signal by the delay circuit 304 or 305, (namely, an interval of sampling of the information signals by each sample-and-hold circuit) is set to a value shorter than the time required for the conversion to digital information performed by the AD converter circuit 309.

### 1.2 Operation of AD conversion

A description will be given of an operation of removing noise by the AD converters 151, 152 of the power conversion device configured as described above. Fig. 3A shows a waveform of the voltage Vconv detected by the resistor 113 on the converter side. Fig. 3B shows a waveform of the voltage Vinv detected by the resistor 112 on the inverter side. In Figs. 3A and 3B, interference between the voltage on the converter side and the voltage on the inverter side can be seen. When the power conversion device of Fig. 1 is operated, the information showing values of the voltages Vconv and Vinv shown in Fig. 3A and Fig. 3B is inputted into AD converters 151, 152 respectively as current information.

The voltage on the converter side Vconv has a basic waveform in which the voltage is increased during ON state of the IGBT 104 (t1 to t3, t4 to t7), and is decreased during OFF state of the IGBT 104 (t3 to t4, t7 to t8). The pulse-shaped noise is superimposed on the basic waveform at timings of each drastic variation of the voltage on the inverter side Vinv (t1, t2, t5, t6). The voltage on the inverter side Vinv drastically varies at timings of a changeover of ON/OFF states of the IGBT in the inverter circuit (three-phase bridge circuit) 107. Meanwhile, on the waveform of the voltage on the inverter side Vinv, information regarding the current of each phase of the motor 108 appears with time-division manner, and the pulse-shaped noise is superimposed on the voltage waveform of the resistor 112 at the timings when the IGBT on the converter side 104 is actually turned ON/OFF (t3, t4, t7, t8).

As described, the superimpositions of the pulse-shaped noise occur on both sides of the converter side and the inverter side at the variation edges of the IGBT, and thus the control circuit 109 is required to remove the pulse-shaped noise. Accordingly, the control circuit 109 removes the pulse-shaped noise using the AD converters 151 and 152.

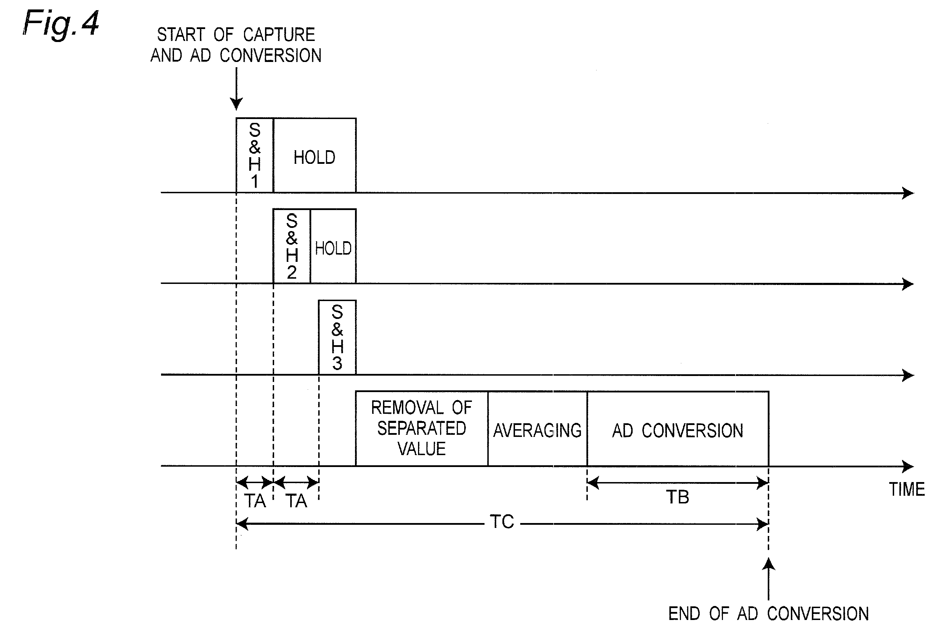

Fig. 4 shows operation timings of the AD converters 151 and 152 of Fig. 2. The AD converter on the converter side 151 and the AD converter on the inverter side 152 may have the same circuit configurations, and therefore the operation timings may also be the same. The operation is described below with an example where the AD converter on the converter side 151 performs the AD-conversion of the current information detected by the resistor 113 as the voltage Vconv. When the AD converter 151 receives the operation start signal which instructs to capture an analog value and perform the AD-conversion of the same from the overall system (an air conditioner etc.) in which the power conversion device of this embodiment is incorporated, the three sample-and-hold circuits 301, 302, and 303 are sequentially operated so that the current information detected at the resistor 113 as voltage is captured.

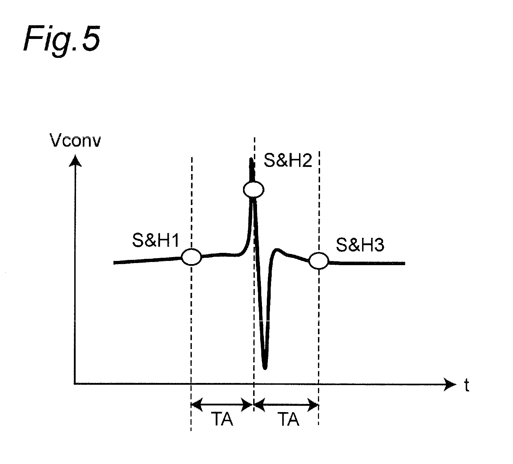

Fig. 5 shows an example of the timings of sampling by the three sample-and-hold circuits 301, 302, and 303. The sample-and-hold circuits 301, 302, and 303 capture current information Vconv at intervals of predetermined delay time TA in accordance with the operation start signal passed through the delay circuits 304 and 305 of Fig. 2. The predetermined delay time TA is set to be larger than a time width of the pulse-shaped noise included in the information signals. Further, as shown in Fig. 4, the predetermined delay time TA is set to a value shorter than time TB which is a time width required for the AD conversion.

Referring to Fig. 4 again, the sample-and-hold circuits 301 and 302 hold captured values until the sample-and-hold circuit 303 captures the current information. When the capturing of the information signals is completed in all of the three sample-and-hold circuits 301, 302, and 303, the captured values are inputted into the separated value removing circuit 307. The separated value removing circuit 307 removes the value farthest from the other values from the captured three sampled results. In Fig. 5, the pulse-shaped noise is ridden near the timing of a second sampling, and therefore a result of the second sample-and-hold shows a value greatly different from the other values. Accordingly, the separated value removing circuit 307 removes the value of the second sample-and-hold, and allows only the first and third sample-and-hold values to be passed.

The two sample-and-hold values passed through the separated value removing circuit 307 are averaged by the averaging circuit 308, and the averaged value is sent to the AD converter circuit 309. The AD converter circuit 309 performs the AD-conversion of the averaged value.

Since the value farthest from the other values is removed by the separated value removing circuit 307, the signal outputted from the AD converter circuit 309 becomes the signal from which the noise is removed. The signal with the noise removed is sent to the converter controller 111. In similar way, the signal with the noise removed by the AD converter 152 is sent to the inverter controller 110.

### 1.3 Summary

According to the power conversion device of this embodiment, the pulse-shaped noise which is caused due to an inductance of a wiring and the like and included in the information about the current etc. being important for power conversion can be removed by the AD converters 151, 152. Therefore, highly accurate information can be quickly obtained by a simple method using resistors etc., and the control accuracy in power conversion can be enhanced. According to the power conversion device of this embodiment, the information can be sensed with the pulse-shaped noise removed, and therefore highly accurate power conversion control can be realized by a simple sensing method. Thus, the power conversion device of this embodiment can be applied to the use in washing machines etc. which utilize electric power as well as home or business use air conditioners and refrigerators. Further, the power conversion device of this embodiment can also exhibit advantageous effects in the case where a plurality of AC loads to be controlled such as motors are provided.

Particularly, as is apparent from a timing chart of Fig. 4, according to this embodiment, predetermined delay time TA, being an interval of sampling, is set to a value shorter than time TB required for conversion to digital information. Therefore, time TC which is the time from an input of the analog information to a final acquisition of digital information, is largely shortened when compared with a general noise removing method shown in Fig. 12. Thus, the noise can be removed without causing the delay in the acquisition of the information. Further, according to this embodiment, AD conversion is not performed at every time each of the analog values are captured but the AD conversion is performed after the averaging processing. Accordingly, the time TC required for acquiring the digital information can still more be shortened. Thus, the power conversion device of this embodiment can realize stable and highly accurate control.

Further, according to this embodiment, AD conversion is performed after the computational operations for removing the noise (namely, processing therefor is performed by a simple analog circuitry). Thus, there is also an advantage that the circuitry can be made simple.

As shown in Fig. 5, since the noise is short pulse-shaped noise, there is hardly any possibility that two sample-and-hold values out of three sample-and-hold values are disturbed. Therefore, a great pulse-shaped noise can be sufficiently removed by the method of this embodiment. Further, when the pulse-shaped noise is generated during the delay between sampling-and-holdings of three sample-and-holds, none of the sampled-and-held values is disturbed, and therefore removal of the great pulse-shaped noise can be realized.

In this embodiment, the delay time TA in each of the sampling-and-holdings is set to be greater than the time width of the pulse-shaped noise included in the information signals of analog input. Therefore, two or more noise values are not sampled-and-held. Accordingly, an influence of the noise can be sufficiently removed by removing the farthest information from the sampled-and-held information.

Further, in this embodiment, resistors 112, 113 are inserted to a place where the current is desired to be detected, and the current information is obtained through a potential difference between both ends of the resistors. Therefore, according to this embodiment, the pulse-shaped noise can be removed with a simple detection method, and the control accuracy of power conversion can be enhanced. In power conversion, it is often the case that the current information drastically varies as the route through which the current flows is changed. In other words, it is the current information that is most remarkably indicative of the control state. Accordingly, highly accurate power conversion can be realized by quickly capturing the variation of the information.

Note that, according to this embodiment, three sample-and-hold circuits are provided and three analog information signals are sampled-and-held. However, the number of sampling-and-holding is not limited to three. For example, the number of the sample-and-hold circuits and the number of sampled-and-held values may be four or more. The greater the number of the information signals used for computation is, the further accurate values can be calculated. Therefore, the number is preferably three or more.

### Embodiment 2

The power conversion device of Embodiment 2 is different from the power conversion device of Embodiment 1 in configurations and operations of the AD converters 151, 152. The AD converters 151, 152 of Embodiment 1 perform the AD conversion at the very end. In contrast, according to Embodiment 2, the AD conversion is performed immediately after the sampling-and-holding. In other words, AD conversion circuits are provided at the lower of each of the sample-and-hold circuits so that removal of a separated value and averaging computation are carried out digitally after all the values are firstly converted to digital information. By this, the AD converters 151, 152 can easily be realized as a large scale integrated circuit (LSI). Embodiment 2 is the same as Embodiment 1, except for the configurations and operations of the AD converters 151, 152.

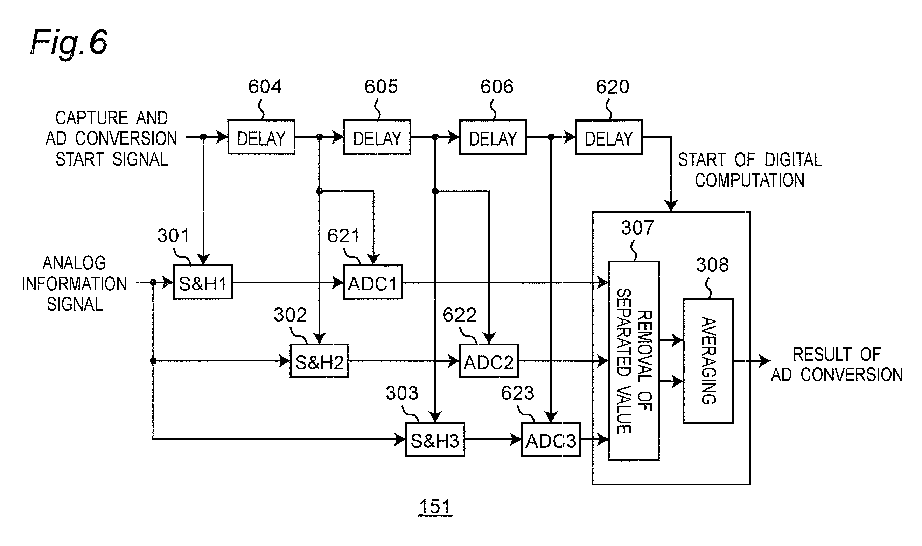

Fig. 6 shows a configuration of the AD converter 151 according to Embodiment 2 of the present invention. The AD converter 152 also has the configuration shown in Fig. 6. The configuration and operation thereof will be described below, with AD converter 151 taken as an example. The AD converter 151 includes: three sample-and-hold circuits 301, 302, and 303 which capture analog inputs as an information signals; AD conversion circuits 621, 622, and 623 which convert resultant outputs from the three sample-and-hold circuits 301, 302, and 303 to digital information; and delay circuits 604, 605, 606, and 620 which delay the operation start signal for instructing the start timing of sample-and-hold and AD conversion by a predetermined time. The sample-and-hold circuit 302 and the AD conversion circuit 621 operate based on the operation start signal passed through the delay circuit 604. The sample-and-hold circuit 303 and the AD conversion circuit 622 operate based on the operation start signal passed through the delay circuits 604, and 605. The AD conversion circuit 623 operates based on the operation start signal passed through the delay circuits 604, 605, and 606. The AD converter 151 further includes: a separated value removing circuit 307 which removes the value farthest from the other values from the information signals each of which has been converted to the digital information; and an averaging circuit 308 which averages the values that has not been removed. Output from the averaging circuit 308 is the resultant of the AD conversion result with the noise removed.

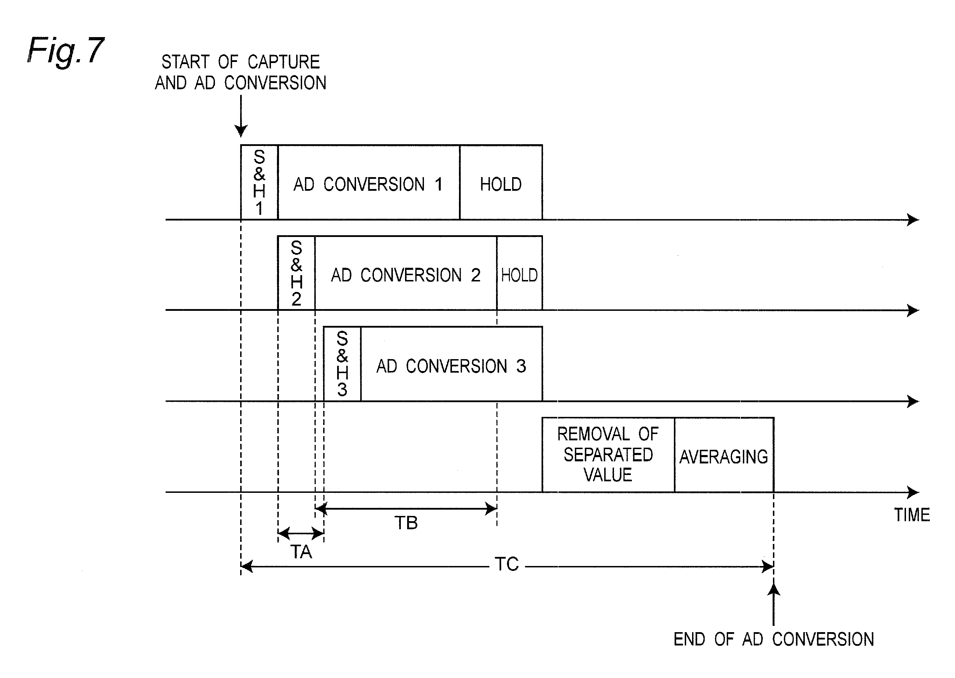

Fig. 7 shows an operation timing of the AD converter 151 of Fig. 6. When the AD converter 151 receives the operation start signal for instructing capturing an analog value and starting AD conversion of the same from the overall system such as an air conditioner in which the power conversion device of Fig. 1 is incorporated, the three sample-and-hold circuits 301, 302, and 303 operate sequentially so that analog information at that time (current information detected by the resistors 112 and 113 of Fig. 1, for example) is captured. Results of the three sample-and-hold circuits 301, 302, and 303 are immediately sent to the AD conversion circuits 621, 622, and 623. The AD conversion circuits 621, 622, and 623 convert the results of the sample-and-hold to digital information based on the operation start signal outputted from the delay circuits 604, 605, and 606. When respective AD conversion is completed, obtained result is held. At the point that the final AD conversion completes, three AD conversion results are all available. Thereafter, the obtained digital information is sent to the separated value removing circuit 307. The separated value removing circuit 307 removes the digital information having the value farthest from the other values from the acquired digital information, and sends the values which are not removed to the averaging circuit 308. The averaging circuit 308 performs averaging of the acquired values.

As shown in Fig. 7, predetermined delay time TA by the delay circuits 604, 605, and 606 (namely, timing of sample-and-hold) is set to a value shorter than the time TB required for conversion to digital information by the AD conversion circuits 621, 622, and 623, Similarly to Embodiment 1. Thus, similarly to Fig. 4, the time TC, the time from reception of the operation start signal to end of the AD conversion, gets shorter than the time of Fig. 12 according to a conventional method. Note that the delay time of the delay circuit 620 may be set to the time required for the conversion to digital information by the AD conversion circuit 623.

According to this embodiment, similar advantageous effects as those of Embodiment 1 can be obtained. In other words, the noise can be removed in short time, and the stable and highly accurate control can be realized.

In this embodiment, removal of separated values and averaging computation are carried out after digital conversion, and therefore the number of circuitry elements is increased compared with Embodiment 1. However, not so much excellent performance is not required to each circuitry element, and therefore there is an advantage in that it is easily embodied as a large scale integrated circuit (LSI).

### Embodiment 3

The power conversion device of Embodiment 3 is different from the power conversion devices of Embodiments 1 and 2 in configurations and operations of the AD converters 151 and 152. In the AD converters 151 and 152 of Embodiments 1 and 2, the separated value removing circuit 307 removes the farthest value. In contrast, a maximum value and a minimum value are removed in Embodiment 3. In Embodiment 3, the other configurations and operations are the same as those of Embodiment 1.

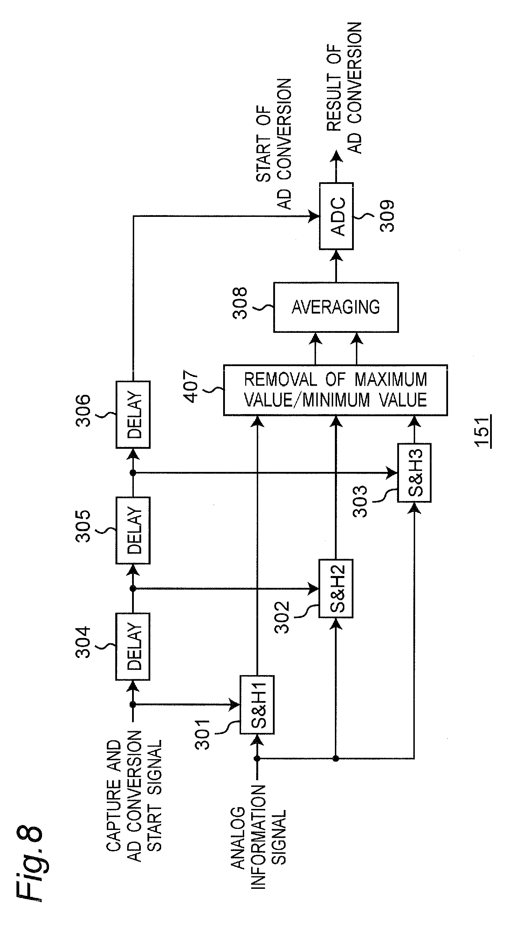

Fig. 8 shows the configuration of the AD converter 151 according to this embodiment. The AD converter 152 may also have the configuration shown in Fig. 8. The configuration and operation thereof will be described below, with the AD converter 151 as an example. The AD converter 151 of this embodiment uses a maximum value/minimum value removing circuit 407 which removes a signal having a maximum value and a signal having a minimum value from inputted signals in place of the separated value removing circuit 307 shown in Fig. 2.

An operation of removing noise by the AD converter 151 of this embodiment will be described, with reference to a waveform of Fig. 5. In the case of the waveform shown in Fig. 5, the maximum value is second sampled-and-held value and the minimum value is third sampled-and-held value. Accordingly, the maximum value/minimum value removing circuit 407 removes the second and third sampled-and-held values and outputs first sampled-and-held value. The first sampled-and-held value is not disturbed by the pulse-shaped noise and therefore a signal with influence of the noise removed is obtained from the output of the averaging circuit 308. Note that in this example, since one value is inputted to the averaging circuit 308, input and output into/from the averaging circuit 308 show the same values.

In this embodiment as well, similarly to Embodiment 1, the delay time TA is set to a value shorter than the time TB required for conversion to digital information by the delay circuits 304 and 305 (see Fig. 4).

According to this embodiment, the same advantageous effects as those of Embodiment 1 can be obtained. In other words, the noise can be removed in a short time, and the stable and highly accurate control can be realized.

Note that according to this embodiment, three sample-and-hold circuits are provided and three values are sampled and held. However, the number may be set to four or more. When four or more sample-and-hold circuits are used, a plurality of information signals is obtained after the removal of the maximum and minimum values. Therefore, the plurality of signals can be averaged by the averaging circuit 308. In this case as well, the value from which the influence of the noise is removed can be outputted as the AD-converted value.

Note that similarly to Embodiment 2, the AD conversion circuits 621, 622, and 623 may be provided at the immediate lower of the sample-and-hold circuits 301, 302, and 303. In this case, after all values are converted to the digital information first, the maximum value and the minimum value are removed through digital computation, and a result thereof is subjected to the averaging computation.

### Embodiment 4

The power conversion devices according to Embodiments 1 to 3 convert an AC power outputted from the AC power supply 101 and supply the converted electric power to a motor. In contrast, a power conversion device of Embodiment 4 converts a DC power outputted from a DC power supply and supplies the converted electric power to a motor. The power conversion device of this embodiment may include the AD converters 151 and 152 of any one of Embodiments 1 to 3.

Fig. 9 shows a configuration of the power conversion device according to Embodiment 4 of the present invention. The power conversion device of this embodiment includes: an inverter A 827 and an inverter B 817 which convert the DC power outputted from a DC power supply 806 to AC power; and a control circuit 809 which controls the inverter A 827 and the inverter B 817. The inverter A 827 and the inverter B 817 may be realized using a three-phase bridge circuit. The AC power outputted from the inverter A 827 and the inverter B 817 is supplied to motors 828 and 818. Thus, the motor 818 and the motor 828 are independently controlled. Current detection resistors 822, 812 are connected between the DC power supply 806 and the inverter A 827 and between the DC power supply 806 and the inverter B 817, respectively. Instantaneous voltages across both ends of the current detection resistors 822 and 812 can be detected by using a minus side of the DC power supply 806 as a reference potential and detecting voltages of the current detection resistor 822 of the inverter A 827 and the current detection resistor 812 of the inverter B 817. Thus, instantaneous currents of two motors 828 and 818 (current values of the inverters 828 and 817) can be known. The control circuit 809 includes: AD converters 151 and 152 which input analog information (such as information showing a current value of the inverter A 827 or the inverter B 817 or information showing a voltage value of the DC power supply 806) and perform an AD-conversion of the analog information; and an inverter A controller 820 and an inverter B controller 810 which control the inverter A 827 and the inverter B 817 respectively based on the output of the AD converters 151 and 152. Instantaneous currents of the motors 828 and 818 are detected by the current detection resistors 822 and 812. The inverter A controller 820 and the inverter B controller 810 can highly accurately drive each one of the motors 828 and 818 by using the aforementioned current value information.

Fig. 10A shows a resistance voltage Va of the current detection resistor 822 on the inverter A 827 side. Fig. 10B shows a resistance voltage Vb of the current detection resistor 812 on the inverter B 817 side. These resistance voltages Va and Vb are inputted into the AD converters 151 and 152 as current information. As shown in the current information obtained from two current detection resistors 812 and 822 of Fig. 10, at the timing when a current vary drastically, the other current is affected so that the pulse-shaped noise is ridden on the other current wave form. For this reason, in this embodiment as well, the pulse-shaped noise is removed by the AD converters 151 and 152.

Configurations of the AD converters 151 and 152 of this embodiment may be the same as those of the AD converters 151 and 152 of any one of Embodiments 1 to 3. In short, the interval (delay time) TA of sampling is set to a value shorter than the time TB required for conversion to digital information performed by the AD conversion circuit 309 (see Fig. 4).

Configurations of the AD converters 151 and 152 of this embodiment are the same as those of the AD converters 151 and 152 of any one of Embodiments 1 to 3, and therefore according to this embodiment, similar advantageous effects as those of Embodiments 1 to 3 can be obtained. In other words, the noise can be removed in short time, and the stable and highly accurate control is made possible.

Further, according to this embodiment, a plurality of motors can be driven accurately with simple configurations. When the plurality of motors are respectively driven with a plurality of inverters as described in the embodiment, a pulse-shaped leak current may flow at a stray capacitance between a motor and its casing (covering casing), and the leak current may sometimes flow through another mother and be mixed into an inverter system of the other motor as noise. Therefore, when the plurality of motors is respectively driven with the plurality of inverters, the removal of the noise according to this embodiment exhibits a great effect.

Although the plurality of motors is driven with the DC power supply in this embodiment. It is to be noted that the plurality of motors may also be driven with the AC power supply. In this case, similarly to the configuration shown in Fig. 1, DC-like power obtained by rectifying and smoothing the output from an AC power supply may be used. In this case as well, advantageous effects similar to this embodiment can be obtained.

Specific embodiments of the present invention have been described. However, other various modified examples, corrections, and other usage are also clarified for a person skilled in the art. Therefore, the present invention is not limited to a specific disclosure of this invention, and can be limited only by the claims attached hereto.

### INDUSTRIAL APPLICABILITY

According to a digital conversion device of the present invention, noise can be removed in short time, and therefore a power conversion device using the digital conversion device is capable of realizing stable and highly accurate power conversion control, and is useful in washing machines etc. which utilize electric power as well as home or business use air conditioners and refrigerators.

### REFERENCE SINGS LIST

- 101:: AC power supply
- 102:: Diode bridge
- 103:: Reactor
- 104:: IGBT
- 105:: Diode
- 106:: Smoothing capacitor
- 107, 817, 827:: Inverter circuit
- 108, 818, 828:: Motor
- 109, 809:: Control circuit
- 110, 810, 820:: Inverter controller
- 111:: Converter controller
- 112, 113, 812, 822:: Resistor
- 116:: Converter circuit
- 151, 152:: AD converter
- 301, 302, 303:: Sample-and-hold circuit
- 304, 305, 306, 604, 605, 606, 620:: Delay circuit
- 307:: Separated value removing circuit
- 308:: Averaging circuit
- 309, 621, 622, 623:: AD converter circuit
- 407:: Maximum value/minimum value removing circuit
- 806:: DC power supply

## Claims

1. A digital conversion device, comprising:
a plurality of information signal holding units capable of inputting information signals with delay by a predetermined time, the information signals being indicative of a value varying momentarily, and holding the values at a time when each of the values is inputted;
a removing unit capable of removing a value farthest from the other values among the values held by the plurality of information signal holding units;
an averaging unit capable of averaging the values that are not removed by the removing unit; and
a converter capable of performing AD-conversion of a value outputted from the averaging unit and outputting an AD-converted value as digital information,
wherein the predetermined time has a value shorter than time required for the conversion to the digital information performed by the converter.

2. A digital conversion device, comprising:
a plurality of information signal holding units capable of inputting information signals with delay by a predetermined time, the information signals being indicative of a value varying momentarily, and holding the values at a time when each of the values is inputted;
a plurality of converters capable of performing AD-conversion of the values held by the plurality of information signal holding units and outputting digital values;
a removing unit capable of removing a digital value farthest from the other digital values among the digital values outputted from the converters; and
an averaging unit capable of averaging the digital values that are not removed by the removing unit and outputting an averaged value as digital information,
wherein the predetermined time has a value shorter than time required for the conversion to the digital value performed by each one of the plurality of converters.

3. The digital conversion device according to claim 1 or 2, wherein a number of the information signals held by the plurality of information signal holding units are three or more.

4. The digital conversion device according to claim 1 or 2, wherein the information signals inputted into the plurality of information signal holding units are indicative of current values.

5. The digital conversion device according to claim 1 or 2, wherein the predetermined time is larger than a time width of pulse-shaped noise included in the information signals inputted into the plurality of information signal holding units.

6. The digital conversion device according to claim 1 or 2, wherein the removing unit removes a maximum value and a minimum value.

7. A power conversion device, comprising:
a DC power converter capable of converting an output of an AC power supply to DC power using a switching element;
an AC power converter capable of converting the DC power outputted from the DC power converter to AC power;
a control circuit capable of controlling the DC power converter and the AC power converter based on digital current information;
resistors which are connected to DC power portions in the DC power converter and the AC power converter; and
a digital conversion device of claim 1 or 2,
wherein the digital conversion device detects a direct current in the DC power converter and an alternating current in the AC power converter by detecting voltages of one ends of the resistors with referring voltages of other ends of the resistors as references and converts each of the detected direct current and the detected alternating current to the digital current information.

8. A power conversion device, comprising:
a plurality of AC power converters capable of converting an output from a quasi-DC power supply to a plurality of AC powers, the quasi-DC power supply converting a DC power supply or an AC power supply to a direct current;
a control circuit capable of controlling the plurality of AC power converters based on digital current information;
resistors which are connected to each of routes from the DC power supply or the AC power supply to each of the plurality of AC power converters; and
a digital conversion device of claim 1 or 2,
wherein the digital conversion device detects an alternating current in the plurality of AC power converters by detecting voltages of one ends of the resistors with referring voltages of other ends of the resistors as references and converts each of the detected alternating currents to the digital current information.
